# EUROPEAN PATENT APPLICATION

(11) **EP 3 611 786 A1**
(43) Date of publication of application: **19.02.2020**
(21) Application number: 19190505.8
(22) Date of filing: 07.08.2019
(51) Int. Cl.: H01M 8/0202, H01M 8/0206, H01M 2/20

(54) **CONTACT ELEMENT, PLUG WITH A CONTACT ELEMENT AND CONTACT ARRANGEMENT FOR CONTACTING A BIPOLAR STACK**

(30) Priority: 14.08.2018 DE 102018213688
(71) Applicant: TE Connectivity Germany GmbH, 64625 Bensheim (DE)
(72) Inventor: Schaefer, Maik, 64579 Gernsheim (DE); Stjepanovic, Zoran, 64285 Darmstadt (DE); Schmidt, Helge, 67346 Speyer (DE)
(74) Representative: Grünecker Patent- und Rechtsanwälte PartG mbB

(57) **Abstract**

The invention relates to a contact element (1) for contacting a bipolar plate (47) of a fuel cell stack (49), having a contact body (2) extending along a longitudinal axis (L), which contact body (2) has a channel (8), extending along the longitudinal axis (L) and delimited by at least two channel walls (10, 12) arranged opposite one another transversely to the longitudinal axis (L), for receiving a portion (42) of the bipolar plate (47), wherein the contact body (2) has, on at least one channel wall (10), at least one contact spring (24), protruding into the channel (8), with a cutting edge (26), for contacting the bipolar plate (47), directed towards the opposite channel wall (12). The invention further relates to a plug (46) having a plurality of contact elements (1) and a contact arrangement (70) comprising a bipolar plate (47) and a contact element (1). By way of the cutting edge (26) cutting into a surface (76) of the bipolar plate (47), secure contacting can be guaranteed, which can withstand heavy loads such as vibration loads and/or impact loads.

## Description

The invention relates to a contact element for contacting a bipolar plate of a fuel cell stack, having a contact body extending along a longitudinal axis, which contact body has a channel, extending along the longitudinal axis and delimited by at least two channel walls lying opposite one another transversely to the longitudinal axis, for receiving a portion of the bipolar plate. The invention further relates to a plug for contacting a plurality of bipolar plates of a fuel cell stack, having a housing which is provided with a plurality of contact chambers, which are aligned in parallel, arranged next to one another and open in the direction of the longitudinal axis. Moreover, the invention relates to a contact arrangement comprising a bipolar plate of a fuel cell stack and a contact element having a channel extending in a longitudinal axis and delimited by at least two channel walls lying opposite one another transversely to the longitudinal axis, wherein the bipolar plate is arranged at least partially in the channel.

Contact elements, plugs and contact arrangements of the type mentioned in the introduction are known from the prior art. In the fuel cell stack, the individual cells are layered above one another to form a stack, with each of them being separated by a bipolar plate. The bipolar plates are used to conduct operational media to electrodes of the fuel cells. In order to investigate the performance and/or failure of the fuel cell stack in a vehicle, the bipolar plates between the cells are connected via a plug with a control circuit and the voltage in each cell is measured.

In particular in vehicles, the plugs are exposed to heavy vibration loads and/or impact loads, as a result of which, in an unfavourable case, the contact elements can become detached from the bipolar plates. Vibrations and/or impacts can additionally generate fluctuating voltage values between the bipolar plate and the contact element.

Against this background, the problem of the invention is to create a contact element, a plug and a contact arrangement, which guarantee stable contacting even with heavy loads, in particular in a heavily vibrating environment and/or when there are heavy impact loads.

This problem is solved by the contact element mentioned in the introduction according to the invention to the effect that the contact body has, on at least one channel wall, at least one contact spring, protruding into the channel, with a cutting edge, for contacting the bipolar plate, directed towards the opposite channel wall.

The problem for a plug of the type mentioned in the introduction is further solved, according to the invention, by a contact element according to the invention being fitted in at least one contact chamber.

For the contact arrangement mentioned in the introduction, the problem is solved according to the invention by the contact body having, on at least one channel wall, at least one contact spring, protruding into the channel, with a cutting edge directed towards the opposite channel wall, and said cutting edge cutting into a contact area of the bipolar plate facing the contact spring.

By way of the cutting edge, the contact spring cuts into a surface of the bipolar plate, as a result of which the contact spring is connected to the bipolar plate with a great contact force. The connection is not detached even under heavy loads, for example by vibration loads and/or impact loads. The contact spring and the bipolar plate are thus preferably coupled immovably to one another, as a result of which vibrations occurring can be compensated and the contacting does not fluctuate during operation.

Hereinafter, further developments are specified which can be combined with one another as desired, independently of one another, and are each themselves advantageous per se.

Thus, according to a first advantageous configuration, the contact body can have a substantially U-shaped cross-section in a transverse direction transverse to the longitudinal axis, wherein the two channel walls form the respective limbs of the U-shaped cross-section and are connected to one another by way of a base. As a result, a portion of the bipolar plate can be inserted into the channel at least in a direction transverse to the longitudinal axis until it comes to a stop on the base, and can be encompassed by the contact body. Preferably, an edge portion of the bipolar plate can be inserted into the channel.

The channel can be open at at least one end arranged in a longitudinal direction in the direction of the longitudinal axis. As a result, it is possible to push in the separation plate in the direction of the longitudinal axis. Preferably, the channel can be open at both ends arranged along the longitudinal axis, as a result of which the length of the portion of the bipolar plate along the longitudinal axis, which bipolar plate can be received in the channel, is not delimited by a wall in the direction of the longitudinal axis. This leads to the situation with a plug whereby a high tolerance and/or a misalignment of the bipolar plates of a fuel cell stack can be compensated in the direction of the longitudinal axis, without deforming and/or damaging the bipolar plates. Thus, the bipolar plates can be inserted into the channel of the respective contact element to different depths in the direction of the longitudinal axis, the contact elements being arranged in a plane transverse to the longitudinal axis. This makes it possible to dimension a plug in such a way that it can be plugged with an accurate fit into a receptacle of the stack, even in the case of a high tolerance and/or a misalignment of the stacked bipolar plates, and can contact the respective bipolar plates securely.

According to a further advantageous configuration, the cutting edge of at least one contact spring can extend parallel to the longitudinal axis. Thus, the cutting edge can contact a large contact area when an edge portion is received in the channel, a compact construction of the contact element being guaranteed. Thus, the width can be reduced in the transverse direction of the contact element, since the contact area extends in the longitudinal direction.

In order to compensate a misalignment and/or tolerance of the stacked bipolar plates in the transverse direction, it has proven particularly advantageous when, according to an advantageous embodiment, the contact spring extends away from a base on the channel wall transversely to the longitudinal axis. As a result, the cutting edge can be spaced apart from the base, so that the bipolar plate can be inserted to different depths into the channel in the transverse direction, and can be contacted by the cutting edge in spite of this. Therefore, this configuration gives rise to a high tolerance during alignment of the bipolar plates, in particular in the transverse direction. Preferably, the cutting edge can be arranged closer to the aperture of the channel transversely to the longitudinal axis than to the base, as a result of which the possible contact region of the bipolar plate can be enlarged.

According to an advantageous configuration, the cutting edge can be arranged in the channel between the channel walls. Preferably, the cutting edge can be arranged at an angle between approximately 60° and approximately 120° in relation to the opposite channel wall.

The at least one contact spring can be arranged on the contact body to be elastically deflectable about a pivot axis. Preferably, the pivot axis can be arranged parallel to the longitudinal axis, wherein the at least one contact spring can be connected to the channel wall by way of its base on the pivot axis. The contact spring can be pretensioned in particular in the direction of the opposite channel wall, wherein the spacing between the opposite channel wall and the cutting edge can be smaller than a material thickness of the bipolar plate or at least of the portion of the bipolar plate which can be inserted into the channel for contacting. As a result, when the bipolar plate is inserted into the channel, the contact spring can be deflected elastically about the pivot axis. The cutting edge can be pressed, with the spring force of the contact spring, against the surface of the bipolar plate facing the cutting edge, and contact the bipolar plate securely.

In a further advantageous configuration, the contact spring can taper in the direction transverse to the longitudinal axis, such that the length of the contact spring decreases in the direction of the longitudinal axis as the spacing from the base increases in the direction transverse to the longitudinal axis. As a result, it can be guaranteed that the spring force of the contact spring is distributed over a small contact area, as a result of which the pressure with which the contact spring is contacted by the cutting clamp rises. Therefore, through this configuration, the contacting between the cutting clamp and the bipolar plate can be further improved.

According to a preferred configuration, the contact element can have at least two contact springs which can be arranged adjacent and/or parallel to one another on a channel wall in the direction of the longitudinal axis. As a result of the fact that the at least two contact springs can be arranged on a channel wall, it is possible to create a particularly compact contact element. The only other thing to take into account is a spring path, around which the contact spring can be deflected elastically. In the case where the contact springs are arranged on opposite channel walls, a spring path around which the contact springs are deflected elastically must be taken into account in the case of a plugged-in bipolar plate on both sides of the portion of the bipolar plate situated in the channel, as a result of which the width of the channel would have to be designed to be wider between the channel walls. With this preferred configuration, it is however possible to create a particularly compact plug, with which a sealed stack of the bipolar plates in a fuel cell stack can be contacted.

In order to be able to manufacture the contact element particularly simply and inexpensively, the contact spring and the contact body can be formed in one piece as a monolithic component, in particular as a stamped and bent part. Thus, the contact element can be produced easily in a production process, for example as a stamped and bent part.

The channel wall on which the at least one contact spring is arranged can have at least one window traversing the channel wall. The contact spring can preferably be arranged in the window, the contact spring extending away from a frame of the window transversely to the longitudinal axis. As a result, the channel wall can be prevented from likewise being deflected by the elastic deformation of the contact spring. The contact spring can be deflected to the extent that it can be arranged substantially in a plane with the channel wall. The channel wall can therefore be unaffected by the elastic deflection of the contact spring, since the contact spring is not pressed against the channel wall.

The cutting edge can be formed at a free end of the contact spring, which free end is bent in the direction of the opposite channel wall. The angle at which the cutting edge is cut into the surface of the bipolar plate can be set in a simple manner by the bent end of the contact spring.

According to a further advantageous configuration, at least the cutting edge, preferably the contact element, can be moulded from a stainless steel. Preferably, the stainless steel can have a titanium alloy and/or a chromium-nickel alloy, which can penetrate a coating on the surface of the bipolar plate and prevents corrosion of the bipolar plate on the contact area and/or of the contact element.

The contact element can have a plug-in portion, which can be formed at a free end and can be coated with tin, in order to be able to plug the contact element into an electrical conductor, such as a printed circuit board for example.

The contact element can be provided with an insertion chamfer at a free end arranged in the direction of the longitudinal axis. For example, the corners of the channel walls remote from the base can be steered in the direction away from one another at the free end, so that the channel widens and the insertion of the bipolar plate into the channel is facilitated. Moreover, the bipolar plates can be generated by means of laser cutting or stamping, wherein sharp edges can arise which could damage the contact elements during the plugging-on. This can be prevented by the insertion chamfer.

The channel walls can extend in particular further in the direction of the longitudinal axis than the base, such that the channel walls can overlap the bipolar plate across the contact region. Preferably, the channel walls can taper in the direction of the longitudinal axis of the respective side remote from the base.

The bipolar plates in a fuel cell stack can be provided, for example, with a substantially rectangular cutout, which extends away from an edge in the direction of the longitudinal axis. As a result, the plug can be plugged onto the stack in the longitudinal direction, wherein the plug is flanked by edge portions of the bipolar plate.

The contact elements can receive an edge portion of the bipolar plate delimiting the cutout. In this case, the contact elements in the plug can be arranged in an alternating manner, i.e. the channels are opened transversely in the direction transverse to the longitudinal axis of successive contact elements in opposing directions. Preferably, the contact elements can be fitted in at least two rows of contact chambers in the direction transverse to the longitudinal axis. Using a two-row plug system of a plug, the double pitch can be available for the contact chamber in comparison with a uniform plug system. In this regard, it can be particularly advantageous if the two rows, of the contact elements fitted into the contact chambers, are offset in relation to one another transversely to the longitudinal direction in a depth direction in which the bipolar plates of the fuel cell stack follow one another, such that bipolar plates arranged behind one another are contacted from opposing directions.

The two rows of contact chambers can each adjoin different walls, in particular lying opposite one another, of the housing. The housing can have, on the respective side walls, a slot arranged parallel to the channel and breaking through into the contact chamber, such that the bipolar plate can be inserted through the slot into the channel. The slot can be smaller, in terms of its width in a depth direction transverse to the longitudinal axis, than the width of the channel between the two channel walls, in order to prevent a movement of the contact element in the contact chamber.

In a plug, a relatively large number of contact elements can be used, in particular twelve, wherein a first group can be arranged in a first row and a second group in a second row. The groups can be arranged spaced apart from one another in the transverse direction and can be arranged in an offset manner in relation to one another in the depth direction, preferably by half the spacing of the contact elements of each group, so that the contact elements of the individual groups can contact the stacked bipolar plates in an alternating manner. The plug can, however, also have several contact elements, for example the plug can be provided with a number of contact elements corresponding to the number of bipolar plates to be contacted.

The plug-in portion of the contact element can protrude out of the contact chamber in the direction of the longitudinal axis for connecting to an electrical conductor, in particular a printed circuit board. The plug-in portion can thus be plugged into a plug-in aperture of the electrical conductor.

At least the cutting edge can have a higher strength than the bipolar plate. As a result, a particularly robust contact element can be created, with high resistance with respect to separation and/or deformation. Thus, wear on the cutting edge when cutting into the bipolar plate can be reduced.

Alternatively to this or even in addition, at least the cutting edge can have a greater hardness than the bipolar plate, in particular the surface of the bipolar plate. Thus, resistance against penetration of the bipolar plate into the cutting edge can be prevented and wear on the cutting edge can be further reduced.

Hereinafter, the invention is described in greater detail by way of example using exemplary embodiments with reference to the attached figures. In the figures, elements which correspond to one another in structure and/or function are provided with the same reference symbols.

The combination of features shown and described in the individual exemplary embodiments serves solely the purposes of explanation. According to the above statements, it is possible to dispense with a feature of an exemplary embodiment if its technical effect is of no importance in a particular application. Conversely, according to the above statements, a further feature can be added in an exemplary embodiment if its technical effect is meant to be advantageous or necessary for a particular application.

In the drawings:
- Fig. 1: shows a schematic perspective view of a contact element according to the invention;
- Fig. 2: shows a schematic side view of the contact element depicted in Fig. 1;
- Fig. 3: shows a schematic perspective view of a plug according to the invention;
- Fig. 4: shows a schematic plan view of a plug according to the invention; and
- Fig. 5: shows a schematic front view of a plug according to the invention.

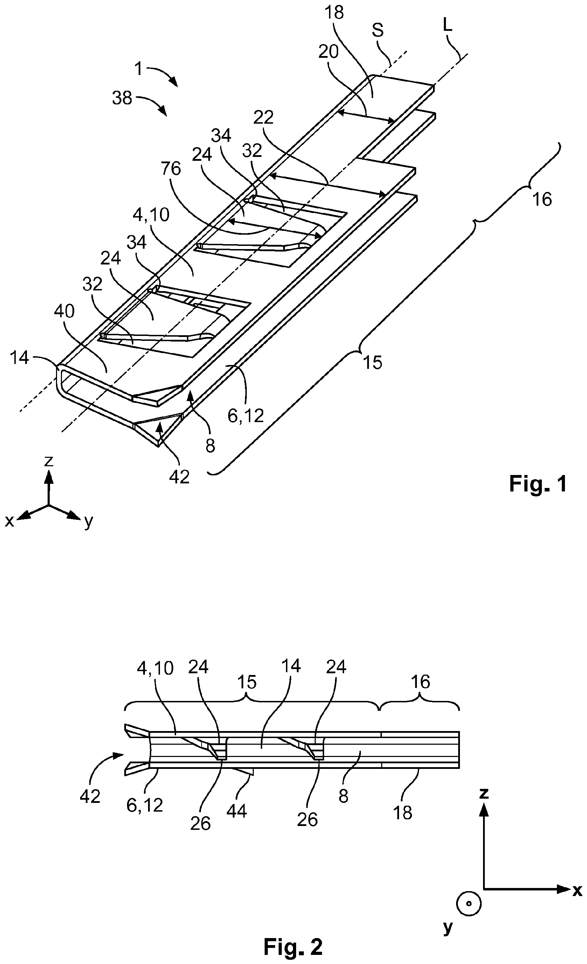

First, the structure of a contact element 1 according to the invention is described with reference to Figs. 1 and 2. For the sake of comprehensibility, a Cartesian coordinate system is used in the description, with a longitudinal direction x, a transverse direction y and a depth direction z.

In this exemplary configuration, the contact element 1 has a contact body 2 extending along a longitudinal axis L. The longitudinal axis L is substantially parallel to the longitudinal direction x. The contact body 2 has a substantially U-shaped cross-section in a plane spanned by the transverse direction y and depth direction z, wherein the limbs 4, 6 are spaced apart from one another in the depth direction transverse to the longitudinal axis L and are arranged substantially parallel to a plane spanned by the longitudinal direction x and transverse direction y. In this case, the limbs 4, 6 delimit a channel 8 in the depth direction z, wherein the limbs 4, 6 function as channel walls 10, 12. The channel 8 is delimited on one side in the transverse direction y by a base 14 connecting the channel walls 10, 12, such that the channel 8 is open at the end remote from the base 14. The channel 8 forms a receiving region 15, in which a portion of a bipolar plate can be received. In this case, the contact body 2 can encompass the portion of the bipolar plate, wherein the channel walls cover the portion.

The contact body 2 has a plug-in portion 16, which extends in the longitudinal direction x and is arranged at an end 18. The width 20 of the channel walls 10, 12 of the plug-in portion 16 in the transverse direction y, in this case, is smaller than the width 22 of the channel walls 10, 12 in the receiving region 15, and can be introduced into a plug-in aperture of an electrical conductor, such as a printed circuit board for example. For this, the plug-in portion 16 is preferably coated in particular with a tin coating, so that the plug-in portion can be attached for example with a solder joint in the plug-in aperture of the electrical conductor.

For contacting a portion of a bipolar plate inserted into the channel 8, the contact element 1 has, on a channel wall 10, two contact springs 24 which protrude into the channel 8 and which are each provided with a cutting edge 26 directed towards the opposite channel wall 12. The contact springs 24 are spaced apart from one another in the longitudinal direction x and extend away from the base 14 in the transverse direction y. The contact springs 24 are elastically deflectable about a pivot axis S on the base 28, which pivot axis S is arranged substantially parallel to the longitudinal axis L, are connected to the channel wall 10 and are pretensioned in the direction of the opposite channel wall 12, such that the contact springs 24 can be deflected in the direction of the channel wall 10 upon insertion of the portion of the bipolar plate.

The cutting edge 26 is formed at a free end 30 of the contact spring 24 remote from the base 14, wherein the free end 30 is bent in the direction of the opposite channel wall 12, so that the cutting edge 26 is arranged at an angle between approximately 60° and approximately 120° to a plane spanned by the longitudinal direction x and the transverse direction y. The surface of the inserted portion of the bipolar plate is preferably arranged parallel to the plane spanned by the longitudinal direction x and transverse direction y. Thus, it can be ensured that the cutting edge 26 contacts the surface of the bipolar plate well.

The cutting edge 26 can be arranged closer to the opposite channel wall 12 than to the channel wall 10, away from which the contact spring 24 extends. Since the bipolar plate in accordance with the contact element 1 depicted in Figs. 1 and 2 is contacted on one side, a spring path around which the contact spring can deflect elastically must be taken into account only on the channel wall 10, which is provided with the contact springs 24. Thus, a particularly compact contact element 1 can be manufactured.

The channel wall 10 is provided with windows 32 which each allow access to a contact spring 24. The contact spring 24 is arranged in the window 32 and extends away from a frame 34 facing the base 14 in the transverse direction y of the base 14. The cutting edge 26 can preferably be arranged closer to the open end of the channel 8 than to the base 14. As a result, incorrect stacking of stacked bipolar plates in the depth direction z can be compensated, since a broad clearance arises between cutting edge 26 and base 14, into which the portion of the bipolar plate can be inserted. The depth to which the portion of a bipolar plate is inserted into the channel in the transverse direction y can vary, with the result that, during plugging-in, a plug can be plugged with an accurate fit into a receptacle of a bipolar plate stack of a fuel cell stack, even in the case of incorrect stacking.

By way of the window 32, the elastic deflection of the contact spring 24 can be prevented from influencing, and likewise deflecting, the channel wall 10. During the deflection, the contact spring 24 does not press against the channel wall 10 and thus does not push said channel wall 10 away from the opposite channel wall 12. Thus, the spacing between the channel walls 10, 12 does not change even when the bipolar plate is inserted.

The contact spring 24 tapers with an increasing spacing from the base 14, such that a length 36 in the longitudinal direction x decreases with an increasing spacing from the base 14 up to the cutting edge 26. The cutting edge 26 can, in this case, extend in the longitudinal direction x with a length of approximately 0.4 mm, for example. As a result, a contact force acting through the spring force of the contact spring 24 can be concentrated on a small contact area.

The contact element 1 can preferably be moulded from a stainless steel, such as a chromium-nickel alloy or a titanium alloy for example. In particular, the contact element 1 can be a monolithic component 38, which can be manufactured simply and inexpensively in a single production process, for example by stamping and bending. The material thickness of the metal sheet can be approximately 0.1 mm thick, for example, wherein the normal force per spring, which acts upon the surface of the portion of the bipolar plate, can be between approximately 1.8 N and 3.5 N, such that the plugging force of a contact element 1 adds up to approximately 5 N.

The contact element 1 has an insertion chamfer 42 at its end 40 remote from the plug-in portion 16, so that when the contact element 1 is plugged onto a portion of the bipolar plate, the insertion of the portion into the channel 8 is facilitated, and the contact element 1 is prevented from being damaged during insertion of the bipolar plate into the channel 8, for example by the sharp edges of the bipolar plate.

The depth of the channel 8 in the depth direction z increases in the region of the insertion chamfer 42. The insertion chamfer 42 can be formed, for example, at the corners 44 of the channel walls 10, 12 which are remote from the base 14, wherein the corners 44 are bent in the direction away from one another. As a result, the insertion chamfer 42 acts both during insertion of the bipolar plate in the longitudinal direction x and also in the transverse direction y.

The channel 8 is opened at both ends in the longitudinal direction x, so that the depth in the longitudinal direction x to which the portion of the bipolar plate can be inserted is not limited, and can vary, thus it is possible to compensate an incorrect positioning of the bipolar plates in the longitudinal direction x.

The contact element 1 is provided, on the channel wall 8 opposite the contact spring 24, with a latching tab 44 deflected in the direction away from the channel 8, with which latching tab 44 the contact element 1 can latch in a contact chamber of a housing of a plug and the contact element 1 can thus be fitted securely into the contact chamber.

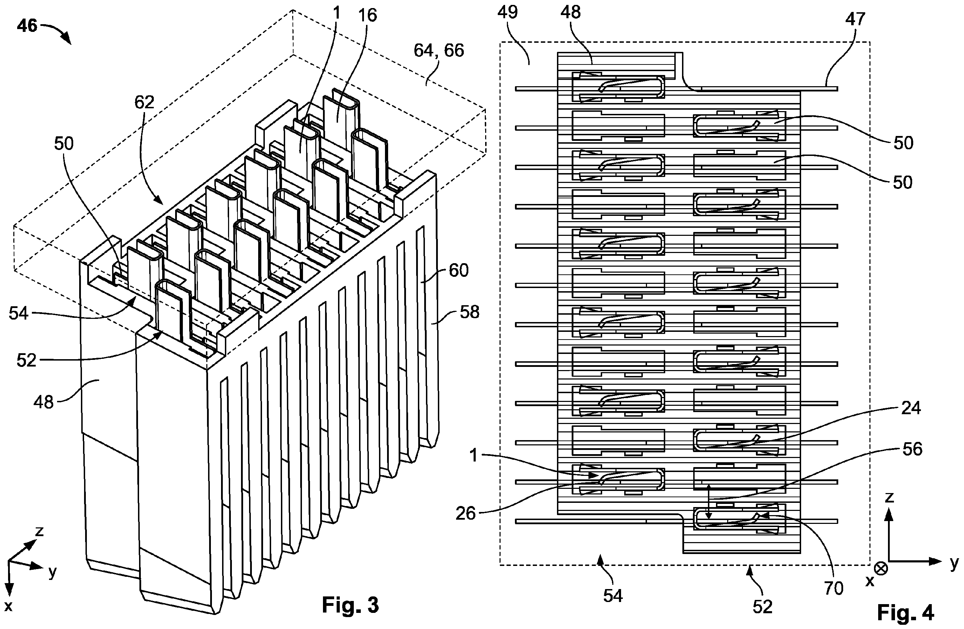

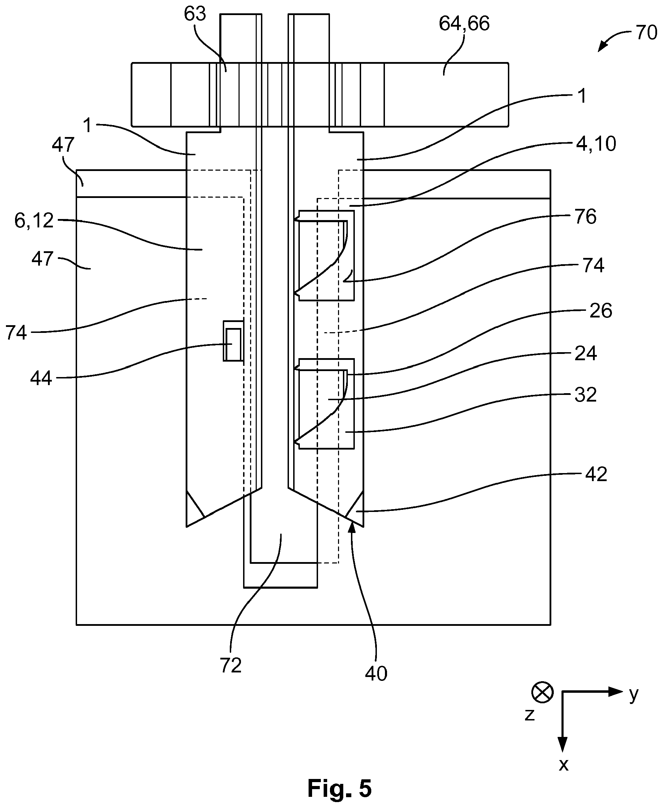

In Fig. 3, an embodiment of a plug 46 according to the invention is depicted in a perspective view and in Figs. 4 and 5 a plug 46 plugged on a stack of bipolar plates 47 of a fuel cell stack 49 is shown in a plan view and a front view respectively.

The plug 46 has a housing 48, which is traversed by a multiplicity of contact chambers 50 in the longitudinal direction x. The housing 48 is electrically insulating and can be manufactured by an injection moulding method, for example. The contact chambers 50 are spaced apart from one another in the depth direction z, wherein a first group of contact chambers 50 is arranged in a first row 52 and a second group of contact chambers 50 in a second row 54. The first and second rows 52, 54 are spaced apart from one another in the transverse direction y and are arranged offset in relation to one another in the depth direction z by the spacing 56 between the contact chambers 50 in a row 52, 54. The spacing 56 corresponds in this case to the spacing between the bipolar plates 47 arranged behind one another.

The first row 52 of contact chambers 50 adjoins a side wall 58, which is traversed by slots 60, in order to make it possible to insert the portion of the bipolar plate 47 into the contact chamber. Similarly to this, the second row 54 of contact chambers 50 adjoins a side wall 62 opposite the side wall 58, which side wall 62 is likewise traversed by slots 60. In this case, the slots 60 are each arranged on a plane perpendicular to the depth direction z with an adjoining contact chamber 50.

As can be seen in Fig. 3 and Fig. 4, contact elements 1 according to the invention are fitted in an alternating manner, so that every second contact chamber 50 in a row 52, 54 is provided with a contact element 1. Since the rows 52, 54 are offset in relation to one another, this means that the contact elements 1 are not arranged in a common plane spanned by the longitudinal direction x and the transverse direction y.

The contact elements 1 are arranged in the rows 52, 54 in such a way that the channel 8 opens in the transverse direction y relative to the adjoining side wall 58, 62.

The plug-in portions 16 protrude out of the contact chamber 50 in the longitudinal direction x and are inserted, and firmly soldered, into insertion apertures 63 of an electrical conductor 64, for example a flexible printed circuit board 66.

In Fig. 5, a contact arrangement 70 comprising a contact element 1 and a bipolar plate 47 is shown. The bipolar plate 47 has a substantially rectangular cutout 72, wherein the cutout 72 should ideally be flush with stacked bipolar plates 47, so that a plug 46 can be inserted with an accurate fit into the cutout 72. However, incorrect positionings can occur frequently, in which the bipolar plates 47 can be arranged offset in relation to one another in the transverse direction y and/or the longitudinal direction x. By way of this offset, the plug 46 can no longer be inserted with an accurate fit into the cutout 72, without deforming the bipolar plates 47.

The bipolar plate 47 has edge portions 74, which flank the cutout 72 and can be inserted into the channel 8 in the transverse direction y and the longitudinal direction x. The depth to which the edge portion 74 can be inserted into the channel 8 in the transverse direction y can vary by the length 76 in the transverse direction y by which the cutting edge 26 is spaced apart from the base 14, wherein the edge portion 74 can be inserted at most until it comes to a stop on the base 14 in the transverse direction y. In the longitudinal direction x, the edge portion 74 can even be inserted until it comes to a stop at the closed end of the slot 60 of the housing 48.

When the edge portion 74 is inserted into the channel 8, the contact springs 24 are deflected elastically by the edge portion 74 about a pivot axis S aligned substantially parallel to the longitudinal axis L, in the direction of the channel wall 10 on which the contact springs 24 are arranged. In this case, the cutting edge 26 cuts into a surface 76, facing the channel wall 10 provided with the contact springs 24, of the edge portion 74 of the bipolar plate 47. The surface 76 is preferably coated, wherein the cutting edge 26 traverses the coating and presses against the surface 76 with great force between approximately 1.8 N and approximately 3.5 N. Since the cutting edge 26 cuts into the surface 76, secure contacting in the contact arrangement 70 can be created, which withstands heavy loads, for example impact loads and/or vibration loads. Thus, the fluctuation in the measurement results during the journey can be reduced.

In Fig. 5, two contact arrangements 70 are shown, wherein the contact arrangements 70 are stacked behind one another and the bipolar plates 47 are arranged offset in relation to one another by an offset in the longitudinal direction x and the transverse direction y. The contact elements 1 are fitted in a plug 46 and can be plugged into the cutout 72, so that an edge portion 74 of the front bipolar plate 47 in the channel 8 of the front contact element 1 and the opposite edge portion 74 of the rear bipolar plate 47 in the depth direction z are arranged in the channel 8 of the rear contact element. The high tolerance of the contact element 1 in the longitudinal direction x and the transverse direction y makes it possible for the plug 46 to be pluggable with an accurate fit into the cutout 72, without bending the bipolar plates out of shape and/or damaging them.

### Reference symbols

- 1: contact element
- 2: contact body
- 4: limb
- 6: limb
- 8: channel
- 10: channel wall
- 12: channel wall
- 14: base
- 15: receiving region
- 16: plug-in portion
- 18: end with plug-in portion
- 20: width of the plug-in portion
- 22: width of the base
- 24: contact spring
- 26: cutting edge
- 30: free end
- 32: window
- 34: frame
- 36: length of the contact spring
- 38: monolithic component
- 40: end
- 42: insertion chamfer
- 44: latching tab
- 46: plug
- 47: bipolar plate
- 48: housing
- 49: fuel cell stack
- 50: contact chamber
- 52: first row
- 54: second row
- 56: spacing
- 58: side wall
- 60: slot
- 62: side wall
- 63: insertion aperture
- 64: electrical conductor
- 66: printed circuit board
- 70: contact arrangement
- 72: cutout
- 74: edge portion
- 76: surface

- L: longitudinal axis
- S: pivot axis
- x: longitudinal direction
- y: transverse direction
- z: depth direction

## Claims

1. A contact element (1) for contacting a bipolar plate (47) of a fuel cell stack (49), having a contact body (2) extending along a longitudinal axis (L), which contact body (2) has a channel (8), extending along the longitudinal axis (L) and delimited by at least two channel walls (10, 12) lying opposite one another transversely to the longitudinal axis (L), for receiving a portion (42) of the bipolar plate (47), **characterised in that** the contact body (2) has, on at least one channel wall (10), at least one contact spring (24), protruding into the channel (8), with a cutting edge (26), for contacting the bipolar plate (47), directed towards the opposite channel wall (12).

2. The contact element (1) according to Claim 1, **characterised in that** the cutting edge (26) of the at least one contact spring (24) extends parallel to the longitudinal axis (L).

3. The contact element (1) according to Claim 1 or 2, **characterised in that** the at least one contact spring (24) extends transversely to the longitudinal axis (L).

4. The contact element (1) according to any one of Claims 1 to 3, **characterised in that** the at least one contact spring (24) is arranged on the contact body (2) to be elastically deflectable about a pivot axis (S).

5. The contact element (1) according to any one of Claims 1 to 4, **characterised in that** the contact element (1) has at least two contact springs (24), which are arranged on a channel wall (10).

6. The contact element (1) according to any one of Claims 1 to 5, **characterised in that** the cutting edge (26) is formed at a free end (30) of the contact spring (24), which free end (30) is bent in the direction of the opposite channel wall (12).

7. The contact element (1) according to any one of Claims 1 to 6, **characterised in that** the at least one contact spring (24) and the contact body (2) are formed in one piece as a monolithic component (38).

8. The contact element (1) according to any one of Claims 1 to 7, **characterised in that** the contact spring (24) extends away from a base (14) which connects the channel walls (10, 12) and delimits the channel (8) in a direction transverse to the longitudinal axis (L), and tapers in the direction away from the base (14).

9. The contact element (1) according to any one of Claims 1 to 8, **characterised in that** at least the cutting edge (26) is moulded from a stainless steel.

10. The contact element (1) according to any one of Claims 1 to 9, **characterised in that** the contact body (2) is provided with an insertion chamfer (42) at an end (40) laid in the direction of the longitudinal axis (L).

11. A plug (46) for contacting a plurality of bipolar plates (47) of a fuel cell stack (49), having a housing (48) which is provided with a plurality of contact chambers (50), which are aligned in parallel, arranged next to one another and open in the direction of the longitudinal axis (L), **characterised in that** a contact element (1) according to any one of Claims 1 to 10 is arranged in at least one contact chamber (50).

12. The plug (46) according to Claim 11, **characterised in that** the plug (46) has at least two rows (52, 54), arranged offset in relation to one another, of contact elements (1).

13. The plug (46) according to any one of Claims 11 or 12, **characterised in that** the at least one contact element (1) has a plug-in portion (16) for connecting to an electrical conductor (64), which protrudes out of the contact chamber (50).

14. A contact arrangement (70) comprising a bipolar plate (47) of a fuel cell stack (49) and a contact element (1), having a contact body (2) extending along a longitudinal axis (L), which contact body (2) has a channel (8), extending along the longitudinal axis (L) and delimited by at least two channel walls (10, 12) lying opposite one another transversely to the longitudinal axis (L), wherein at least one portion (74) of the bipolar plate (47) is arranged at least partially in the channel (8), **characterised in that** the contact body (2) has, on at least one channel wall (10), at least one contact spring (24) with a cutting edge (46) which protrudes into the channel (8), is directed towards the opposite channel wall (12) and cuts into a surface (76) of the bipolar plate (47) facing the contact spring (24).

15. The contact arrangement according to Claim 14, **characterised in that** at least the cutting edge (46) has a higher strength than the bipolar plate (47).
